# EUROPEAN PATENT SPECIFICATION

(11) **EP 1 852 845 B1**
(45) Date of publication and mention of the grant of the patent: **24.11.2010**
(21) Application number: 06113360.9
(22) Date of filing: 02.05.2006
(51) Int. Cl.: G09G 3/32, H01L 27/32

(54) **Organic electroluminescent device and fabrication methods thereof**
Organische Elektrolumineszenzvorrichtung und Herstellungsverfahren
Dispositif électroluminescent organique et méthode de fabrication

(43) Date of publication of application: 07.11.2007
(73) Proprietor: Chimei InnoLux Corporation, Chu-Nan 350 Miao li 350 (TW)
(72) Inventor: Tseng, Chang-Ho, 327, Taoyuan County (TW); Peng, Du-Zen, 302, Hsinchu County (TW); Tsai, Yaw-Ming, 414, Taichung County (TW)
(74) Representative: 2K Patentanwälte Blasberg Kewitz & Reichel

(56) References cited:
- EP-A- 1 096 466
- EP-A1- 0 923 067
- EP-A2- 1 122 792
- WO-A-2004/019123
- US-A1- 2005 007 320
- A. GIRALDO ET AL.: "Optical feedback in active matrix polymer OLED displays" PROCEEDINGS OF THE IEEE LEOS 16TH ANNUAL MEETING 2003, vol. 2, 30 October 2003 (2003-10-30), pages 529-530, XP002401137 IEEE, USA

## Description

### BACKGROUND OF THE INVENTION

### Field of the Invention

The present invention relates to an organic electroluminescent device and fabrication methods thereof, and more particularly to compensation of an organic electroluminescent device.

### Description of the Related Art

Organic electroluminescent devices are also known as organic light emitting diodes (OLED). A voltage is applied to an organic molecular material or polymer material to cause a device to emit light. Due to self emission characteristics of an OLED, dot matrix type displays with light weight, slim profile, high contrast, low power consumption, high resolution, fast response time, no backlight, and wide viewing angle can be achieved. Possible display parameters ranging from 4mm micro-displays to 100 inch outdoor billboards make them a preferred light source for flat panel displays (FPD). If luminescent efficiency of the OLEDs is over 100Lm/W, they can replace conventional lighting.

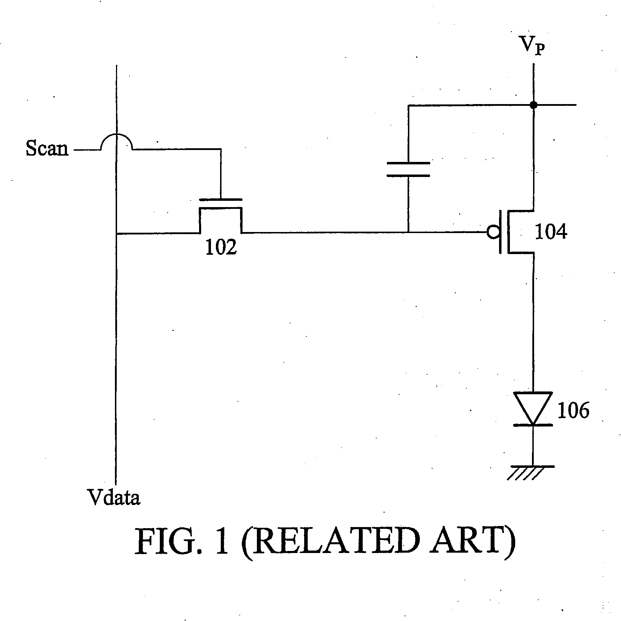

As shown in FIG. 1, an organic electroluminescent device is operated by a switch transistor 102, and a driving transistor 104 coupling to a power line Vp. Organic electroluminescent devices 106, however, suffer from non-uniform brightness between pixels. Specifically brightness of the organic electroluminescent device 106 decays with long term use.

WO 2004/019123 A1 discloses an active matrix electroluminescent display including an electroluminescent according to the preamble of claim 1. The device includes a PIN photodiode. In this PIN diode a) a dielectric layer is interposed between the edge of the P+ lower electrode region of the PIN diode and its intrinsic region; and b) the P+ lower electrode region of the amorphous PIN diode is formed in a polysilicon film, which implies a hybrid of technologies.

The manufacturing of this device requires an enhanced precision and additional process steps.

EP 0 923 067 A1 discloses a display apparatus provided with a current driving LED and a driving device for controlling a driving current flowing through the LED for each pixel. Details of the microelectronic structure are not disclosed.

US 2005/0007320 A1 discloses a display driver circuitry for active matrix displays using OLEDs. Details of the microelectronic structure are not disclosed.

EP 1 096 466 A1 discloses an active matrix electroluminescent display including a photodiode that is optically coupled to an LED within a pixel to detect a portion of the luminous flux generated by the LED. Details of the microelectronic structure are not disclosed.

A. Giraldo et al., "Optical feedback in active matrix polymer OLED displays", Proceedings of the IEEE LEOS 16th annual meeting 2003, vol. 2, 30. October 2003, pages 529-530, XP002401137 IEEE, USA discloses a pixel circuit with optical feedback to compensate for OLED differential degradation. This document also shows a process cross section, which is, however, different with regard to the photosensor.

### BRIEF SUMMARY OF THE INVENTION

It is an object of the present invention to further enhance an OLED device according to the preamble of claim 1 for enabling a precise compensation for OLED differential degradation at reduced processing and manufacturing costs. It is a further object of the present invention to provide a method for manufacturing such an OLED device.

The above objects are accomplished by an OLED device according to claim 1 and by a method according to claim 12. Further advantageous embodiments are the subject-matter of the dependent claims.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:

FIG. 1 illustrates non-uniform brightness between pixels of a conventional organic electroluminescent device; and

FIG. 2 shows an organic electroluminescent device with compensation device in accordance with an embodiment of the invention.

FIGs. 3A~3O show an intermediate cross section of an organic electroluminescent device with compensation device in accordance with an embodiment of the invention.

FIG. 4 shows that the pixel element 20 shown in FIG. 2 or FIG. 3N can be incorporated into a panel (in this case, panel 30) such as an OLED panel.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

The invention will be described in greater detail by referring to the accompanying drawings. In the accompanying drawings, like and/or corresponding elements are referred to by like reference numerals. The following description discloses the best-contemplated mode of carrying out the invention. This description is made for the purpose of illustrating the general principles of the invention and should not be taken in a limiting sense. The scope of the invention is best determined by reference to the appended claims.

In this specification, expressions such as "overlying the substrate", "above the layer", or "on the film" simply denote a relative positional relationship with respect to the surface of a base layer, regardless of the existence of intermediate layers. Accordingly, these expressions may indicate not only the direct contact of layers, but also, a non-contact state of one or more laminated layers.

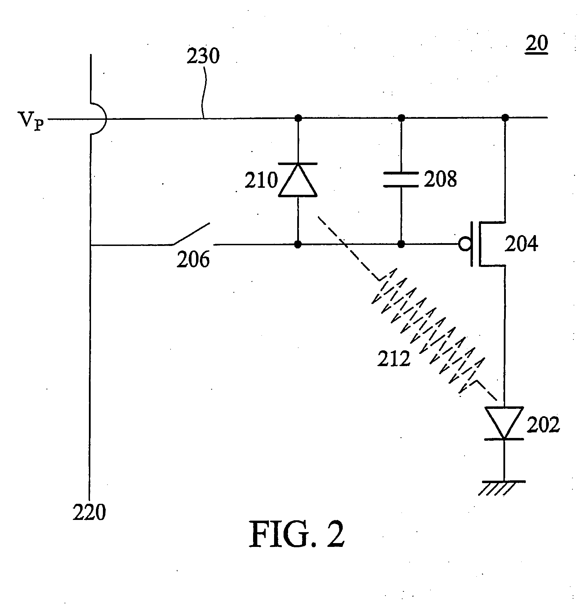

FIG. 2 shows an organic electroluminescent device with compensation device in accordance with an embodiment of the invention. Referring to FIG. 2, the electroluminscent device includes a pixel element 20. In the pixel element 20, an organic electroluminescent element 202 is operated by a switch device 206, such as a switch integrated circuit (IC) or a switch transistor, and a driving device 204 coupling to a power line Vp, also referred to as a driving integrated circuit, driving IC, in which current passing through the driving device 204 is controlled to determine illumination of the organic electroluminescent element 202. The switch device 206 is controlled by a column data line 220 and a row scan line 230. In an embodiment of the invention, a capacitor 208 can be coupled to a gate electrode of the driving device 204, in which the capacitor 208 further couples to a photo diode 210 (serving as a photo sensor). The voltage of the capacitor 208 is adjusted to control the current passing through the driving transistor 204 according to illumination of the organic electroluminescent element 202 detected by the photo sensor 210, thus, illumination 212 of the organic electroluminescent element 202 is changed for compensation.

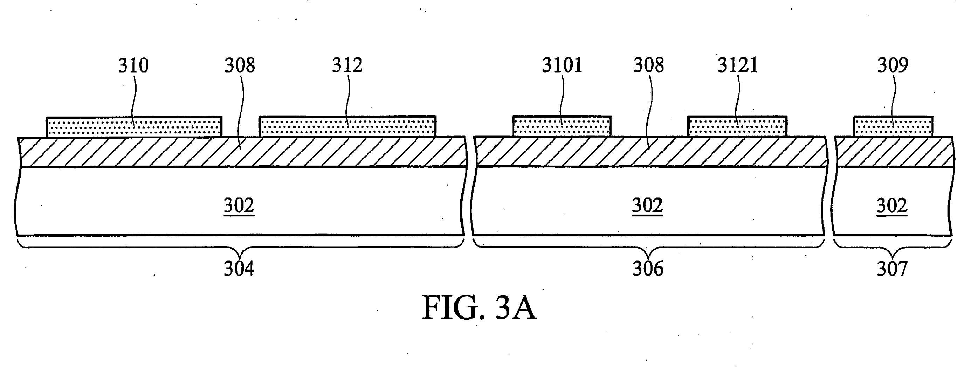

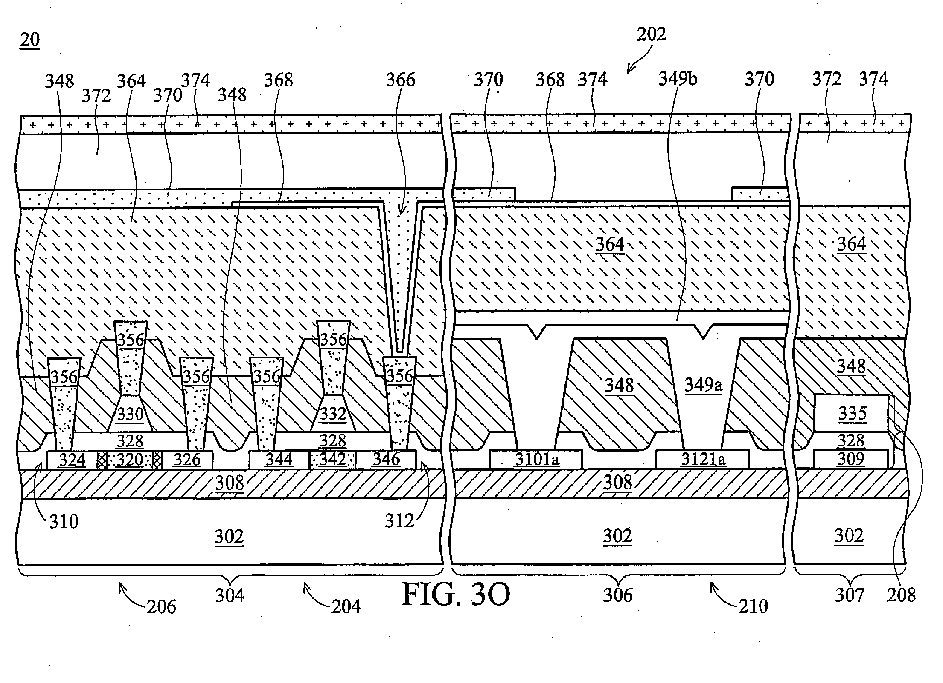

FIG. 3O shows a cross-sectional view of a pixel element 20 of an embodiment of an organic electroluminescent device. FIGS. 3A~3O show an intermediate cross section of an embodiment of an organic electroluminescent device with compensation device. Referring to FIG. 3A, a substrate 302 comprising a control area 304, a sensitive area 306 and a capacitor area 307 is provided, and a buffer layer 308 is formed on the substrate 302. The buffer layer 308 can comprise silicon oxide, silicon nitride, silicon oxynitride or a combination thereof, and preferably is a stack of a silicon oxide layer and a silicon nitride layer. In a preferred embodiment of the invention, thickness of the silicon nitride layer is about 350Å~650Å, and thickness of the silicon oxide layer is about 1000Å~1600Å (10Å =1 nm).

Next, a conductive layer (not shown) is formed on the buffer layer 308. The conductive layer can comprise polysilicon. For example, an amorphous silicon layer is first formed by deposition with chemical vapor deposition and then crystallized or annealed with excimer laser, ELA to form a polysilicon layer. The conductive layer is defined by conventional lithography and etched to form a first active layer 310, a second active layer 312 overlying the control area 304 of the substrate, a third active layer 3101, a fourth active layer 3121 overing the sensitive area 306, and a bottom electrode 309 overlying the capacitor area 307 of the substrate 302.

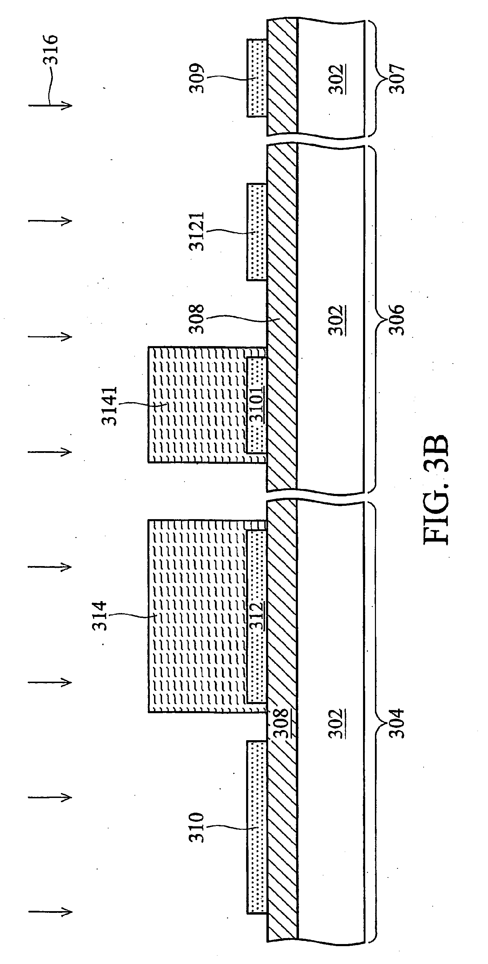

Referring to FIG. 3B, the second active layer 312 and the third active layer 3101 are covered by photoresist layers 314, 3141, respectively. A channel dope dopant 316 is implanted into the active layers 310, 3121, and the bottom electrode 309 in which the dopant 316 thereof preferably comprises B+, and the dosage is typically about 0~1E13/cm2.

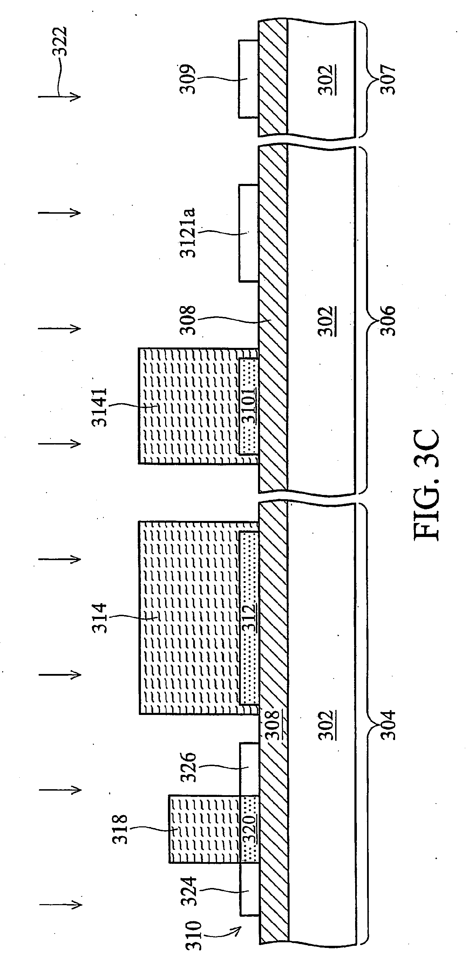

Referring to FIG. 3C, the third active layer 3101 is covered by a photoresist layer 3141, and the second active layer 312 is covered by a photoresist layer 314. A channel region 320 of the first active layer 310 is covered by another photoresist layer 318, implanting N+ ions 322 into the first active layer 310 to form a source 324 and a drain 326 of an n type transistor. In the meantime, N+ ions are implanted into the exposed fourth active layer 3121, and the bottom electrode 309, thus, an N+ region 3121a of a photo diode (serving as a photo sensor) is formed. In a preferred embodiment of the invention, the N+ ions may comprise phosphorous, and the dosage is preferably about 1E14~1E16cm2.

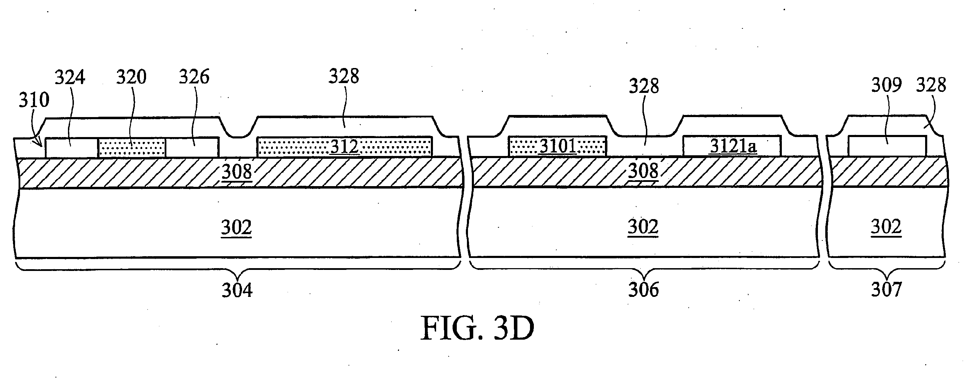

Referring to FIG. 3D, the photoresist layers 314, 3141 and 318 are removed, and a gate dielectric layer 328, for example silicon oxide, silicon nitride, silicon oxynitride, a combination thereof, a stack layer thereof or other high K dielectric material, is blanketly deposited on the first active layer 310, the second active layer 312, the third active layer 3101, the N+ region 3121a of a photo diode and the buffer layer 308, and the bottom electrode layer 309 in the capacitor area 307, in which the gate dielectric layer 328 serves as a capacitor dielectric layer in the capacitor area 307. Deposition of the gate dielectric layer 328 comprises CVD.

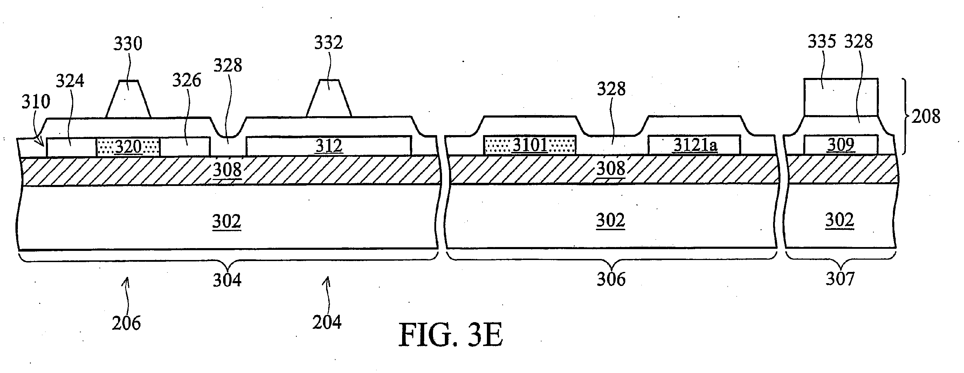

Referring to FIG. 3E, a gate conductive layer (not shown), for example doped polysilicon or metal, is formed on the gate dielectric layer 328. In a preferred embodiment of the invention, the gate conductive layer is Mo and about 1500Å ~2500Å thick.

Next, the gate conductive layer is patterned by conventional lithography and etched to form an n type transistor gate 330 overlying the first active layer 310, a p type transistor gate 332 overlying the second active layer 312, and a top electrode 335 overlying the capacitor area 307. Thus, the bottom electrode 309, the gate dielectric layer 328, and the top electrode 335 constitute the capacitor 208 as shown in FIG. 2.

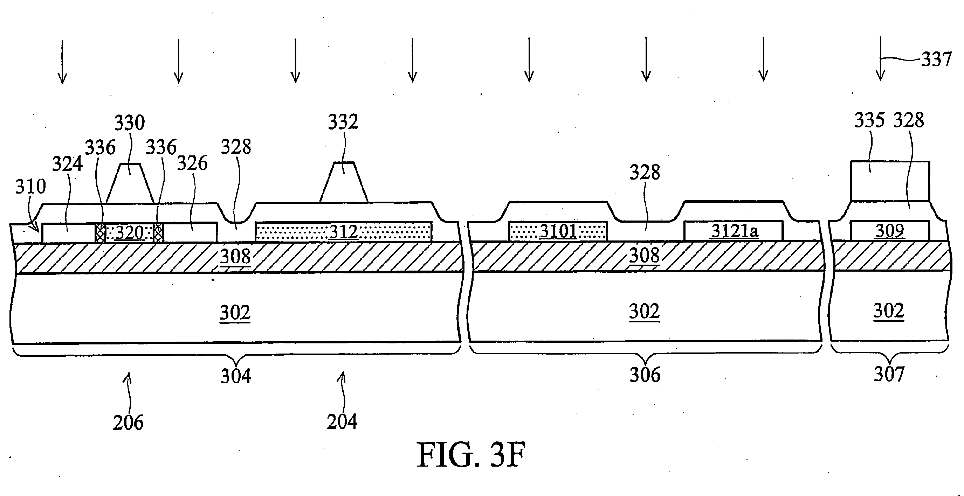

As shown in FIG. 3F, subsequent to the formation of the gate 330 and 332, a light doping (N- doping) 337, for example ion implantation, can be performed to form lightly doped source/drain regions (LDD) 336 on opposite sides of the channel region 320 of the first active layer 310 of the n type transistor. Thus, the switch device 206 of the n type transistor and the driving device 204 of the p type transistor as shown in FIG. 2 are formed in the control area 304. In some embodiments, the switch device 206 and the driving device 204 are top gate transistors.

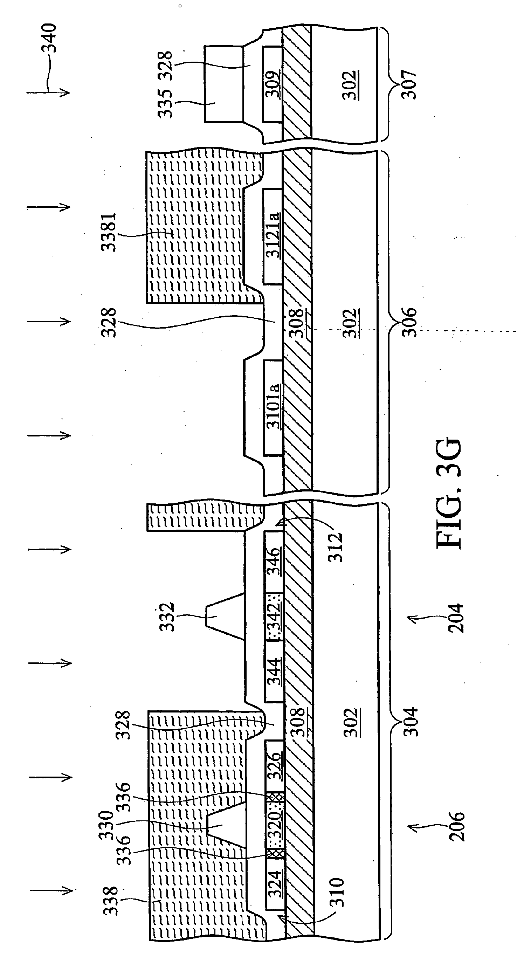

In FIG. 3G, a photoresist layer 338, 3381 are formed to cover the first active layer 310, the N+ region 3121a of a photo diode, respectively. An ion implantation (P+ doping) 340 is performed to form source 344 and drain 346 on opposite sides of the channel region 342 of the p type transistor, and to form an P+ region 3101 a of a photo diode.

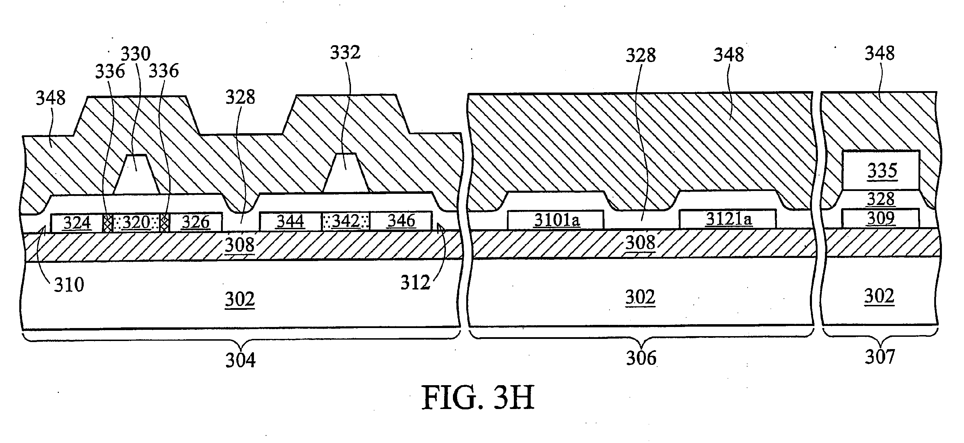

Next, referring to FIG. 3H, the photoresist layer 338 and 3381 are removed. A dielectric layer 348 is blanketly deposited on the gate dielectric layer 328 overlying the control area 304, the n type transistor gate 330, the p type transistor gate 332, the N+ region 3121a and the P+ region 3101 a of a photo diode overlying the sensitive area 306, and the top electrode 335 overlying the capacitor area 307.

Generally, the thickness and composition of the dielectric layer 348 can be determined according to product spec or process window. For example, the dielectric layer 348 may include silicon dioxide, polyimide, spin-on-glass (SOG), fluoride-doped silicate glass (FSG), Black Diamond (a product of Applied Materials of Santa Clara, California), Xerogel, Aerogel, amorphous fluorinated carbon, and/or other materials. In a preferred embodiment of the invention, the dielectric layer 348 is a stack layer of silicon oxide and silicon nitride, and more preferably a lower nitride layer/oxide layer/higher nitride layer structure, in which the lower nitride layer is about 2500~3500Å thick, the oxide layer is about 2500~3500Å thick and the higher nitride layer is about 500~1500Å thick. Formation of the dielectric layer 348 comprises CVD. In addition, a rapid thermal annealing is conducted to activate the dopants.

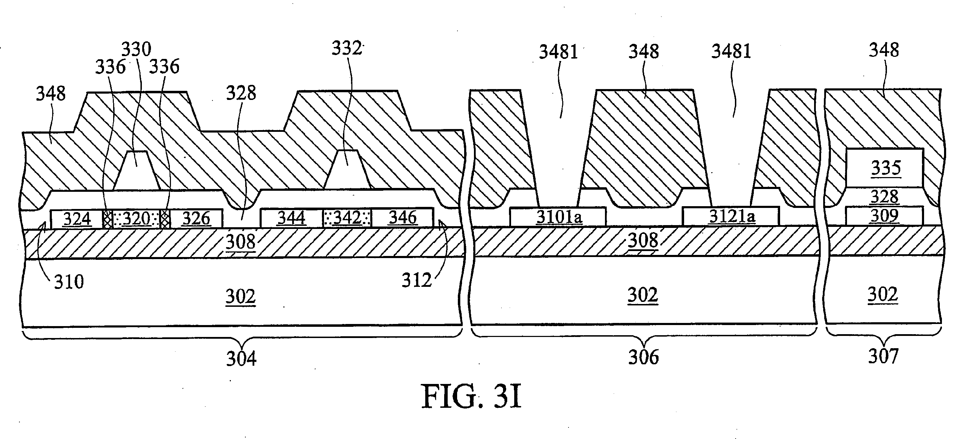

As shown in FIG. 3I, by means of sequential patterning and etching processes, a contact hole 3481 is defined and etched through the dielectric layer 348 and the gate dielectric layer 328 overlying the sensitive area 306. The etching comprises a dry etching or a wet etching.

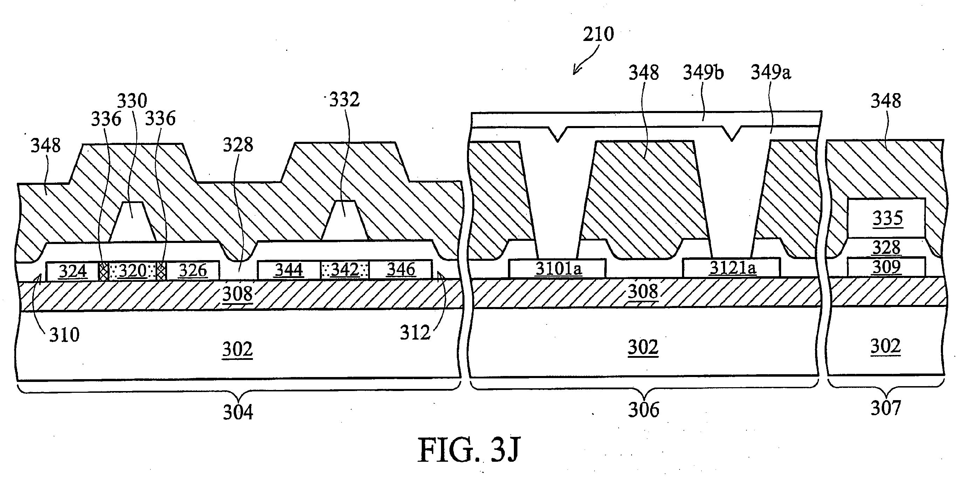

As shown in FIG. 3J, by means of CVD, a conductive film 349a such as an a-Si film and a dielectric film 349b are formed over the sensitive area 306 in sequence. The conductive film 349a fills the contact hole 3481 and overlies the dielectric layer 348. The dielectric film 349b covers the conductive film 349a. The preferred thickness of the conductive film 349a or the dielectric film 349b is 5000 and 3000 angstroms, respectively. The conductive film 349a can be amorphous silicon or polysilicon. The dielectric film 349b can be silicon nitride or silicon oxide. In other embodiments, an a-Si photo diode region is patterned and etched by etching after formation of the conductive film 349a and the dielectric film 349b, thus, the photo sensor 210 as shown in FIG. 2 is formed. The etching process comprises dry etching and wet etching processes. The photo sensor 210 can be a lateral α-Si diode in this embodiment while it can be a vertical diode in other embodiment.

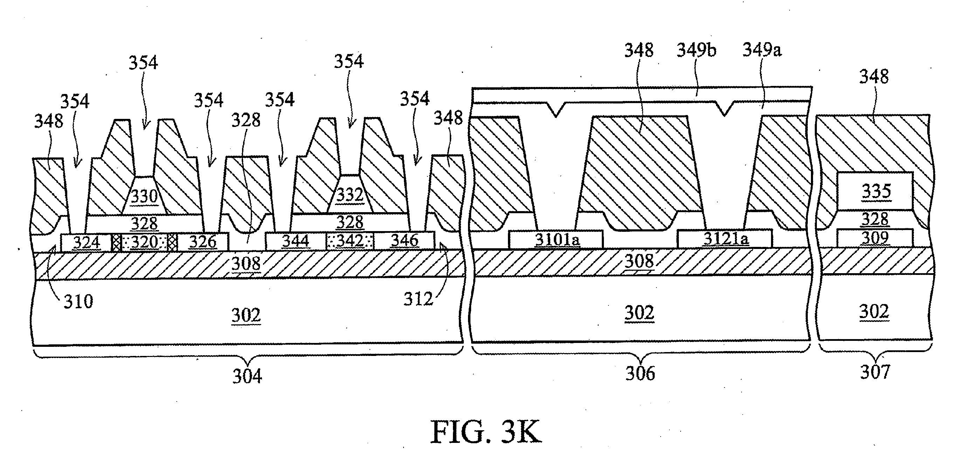

As shown in FIG. 3K, the dielectric layer 348 and the gate dielectric layer 328 are patterned by conventional photolithography and etched to form a plurality of openings 354, exposing the source 324, gate 330 and drain 326 of the n type transistor and the source 344, gate 332 and drain 346 of the p type transistor respectively for connection to metal lines in subsequent processes.

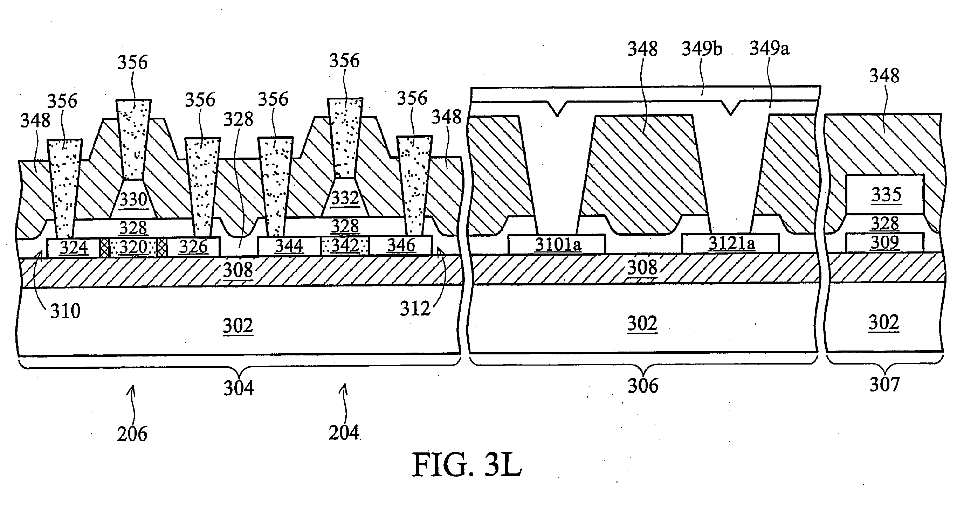

Next, referring to FIG. 3L, a metal layer (not shown) is blanketly deposited, and then patterned by conventional photolithography and etching to form conductive contacts 356 in the openings 354. According to some embodiments of the present invention, the switch device and the driving device can have gates of the same layer. For example, referring to FIG. 3L, the gate 330 of the switch device 206 and the gate 332 of the driving device 204 are of the same layer. The metal layer is a stack of Mo/Al/Mo, each layer with a thickness of 500, 4000, 500 angstroms, respectively.

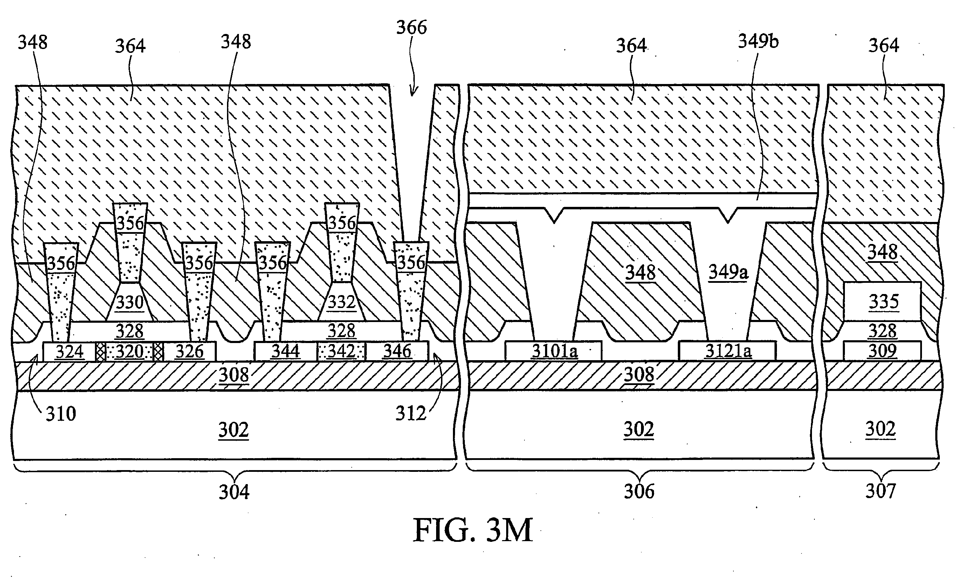

Referring to FIG. 3M, a planarization layer 364 for example organic or oxide, is formed on the passivation layer 362. Preferably, the planarization layer 364 is about 10000Å~50000Å thick. The planarization layer 364 and the passivation layer 362 is patterned by conventional lithography and etched to form contact openings 366 corresponding to the conductive contacts 356. In a preferred embodiment of the invention, the contact opening 366 exposes the conductive contact 356 of the drain 346 of the p type transistor.

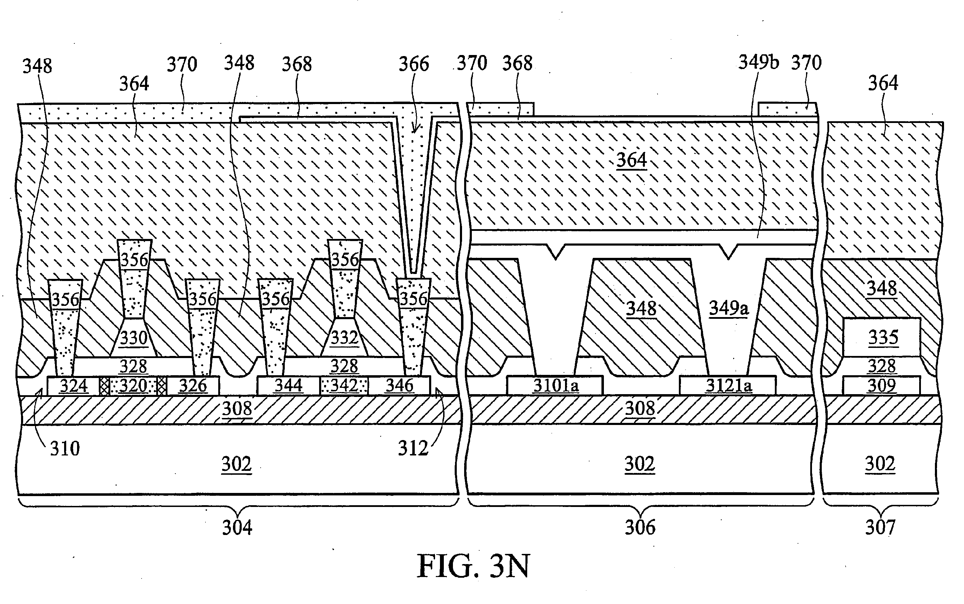

Referring to FIG. 3N, a pixel electrode layer 368 (serving as an anode), for example indium tin oxide (ITO), is formed on the planarization layer 364, electrically connecting the conductive contacts 356. Next, a pixel definition layer 370, for example organic or oxide, is formed on a portion of the planarization layer 364 and the pixel electrode layer 368. The pixel definition layer 370 is then patterned to expose a portion of or the entire photo sensor 210.

Referring to FIG. 3O, an organic light emitting layer (OLED layer) 372 is formed overlying the pixel electrode layer 368 and the pixel definition layer 370. In an embodiment of the invention, the organic light emitting layer 372 disposed overlying the pixel electrode layer 368 (also referred to as an anode layer) comprises a hole-injecting layer, a hole-transport layer, an organic luminescent material layer, an electron-transport layer, and an electron-injecting layer sequentially. The anode layer can be indium tin oxide (In2O3:Sn, ITO) which has advantages of facile etching, low film-formation temperature and low resistance. When a bias voltage is applied to the OLED element, an electron and a hole passing through the electron-transport layer and the hole-transport layer respectively enter the organic luminescent material layer to combine as an exciton and then release energy to return to ground state. Particularly, depending on the nature of the organic luminescent material, the released energy presents different colors of light including red (R), green (G) and blue (B).

Next, a cathode 374 is formed on the organic light emitting layer 372. The cathode 374 can be a reflective layer, for example 1, Ag or other suitable material with high reflectivity. Thus, the pixel electrode layer 368, the organic light emitting layer 372, and the cathode 374 constitute the organic electroluminescent element (OLED element) 202 as shown in FIG. 2. A bottom emission organic electroluminescent device is thus formed.

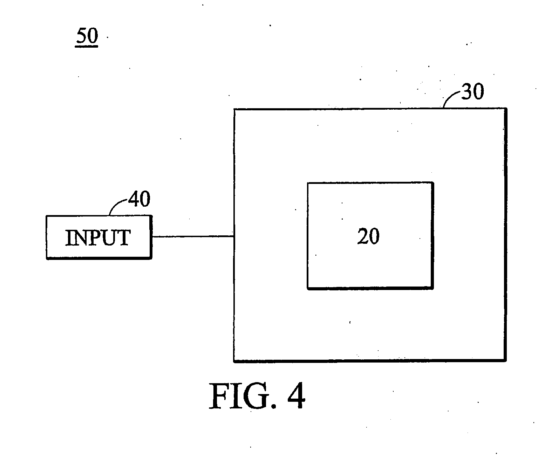

As shown in FIGs. 2 and 3O, according to some embodiments of the invention, photo current is generated in the photo sensor 210 when OLED element 202 illuminates the photo sensor 210. The level of photo current is depending on the brightness of the OLED element 202. Consequently, the voltage of the capacitor 208 coupled to the driving device 204 is adjusted to control the current passing through the driving device 204 according to illumination of the organic electroluminescent element 202 detected by the photo sensor 210. Thus, illumination of the organic electroluminescent element 202 is changed for compensation. This internal compensation can maintain brightness uniformity of the OLED element after long term use. FIG. 4 shows that the pixel element 20 shown in FIG. 2 or FIG. 3O can be incorporated into a display panel (in this case, panel 30) that can be an OLED panel. The panel can form a portion of a variety of electronic devices (in this case, electronic device 50). Generally, the electronic device 50 comprises the OLED panel 30 and an input unit 40. Further, the input unit 40 is operatively coupled to the OLED panel 30 and provides input signals (e.g., image signal) to the panel 30 to generate images. The electronic device can be a PDA (personal digital assistant), notebook computer, tablet computer, cellular phone, car TV, or digital camera, etc.

While the invention has been described by way of example and in terms of the preferred embodiments, it is to be understood that the invention is not limited to the disclosed embodiments.

## Claims

1. An organic electroluminescent device, comprising a pixel element (20), the pixel element comprising:
a substrate (302), comprising a control area (304) and a sensitive area (306);
a switch device (206) and a driving device (204) overlying the control area, wherein the switch device (206) has a first active layer (310), the driving device (204) has a second active layer (312), wherein the first and second active layers are polysilicon layers;
a photo diode (210) overlying the sensitive area, wherein the photo diode serves as a photo sensor;
an OLED element (202) disposed in the sensitive area (306) and illuminating the photo sensor; and
a capacitor (208) coupled to the photo sensor and the driving device;
wherein a photo current corresponding to a brightness of the OLED element (202) is generated by the photo diode responsive to the OLED element illuminating the photo diode such that a voltage of the capacitor is adjusted by the photo current to control the current passing through the driving device, thus changing the illumination of the OLED element;
**characterized in that** said photo diode comprises:
a third active layer (3101), a fourth active layer (3121), and a fifth active layer (349a), wherein the fifth active layer is connected to both the third and fourth active layers;
said organic electroluminescent device further comprising:
a gate dielectric layer (328) disposed overlying the first, the second, the third and the fourth active layers;
a first gate (330) and a second gate (332) disposed on the gate dielectric layer overlying the control area, wherein the first gate is in the switch device, and the second gate is in the driving device; and
an interlayer dielectric layer (348) disposed on the gate dielectric layer (328) overlying the sensitive area, the interlayer dielectric layer having a plurality of first openings (3481) therein to expose the third (3101) and fourth (3121) active layers, wherein the first openings are filled with the fifth active layer (349a).

2. The organic electroluminescent device as claimed in claim 1, wherein the switch device (206) and the driving device (204) are top gate transistors.

3. The organic electroluminescent device as claimed in any of the preceding claims, wherein the photo diode is a lateral photo diode.

4. The organic electroluminescent device as claimed in any of the preceding claims, wherein the third (3101) and fourth (3121) active layers are polysilicon.

5. The organic electroluminescent device as claimed in any of the preceding claims, wherein the third (3101) and fourth (3121) active layers are of different conductivity types.

6. The organic electroluminescent device as claimed in claim 5, wherein the third active layer (3101) is of P-type conductivity and the fourth active layer (3121) is of N-type conductivity.

7. The organic electroluminescent device as claimed in any of the preceding claims, wherein the fifth active layer (349a) is amorphous silicon.

8. The organic electroluminescent device as claimed in any of the preceding claims, wherein the fifth active layer (349a) has a thickness of between 450-550 nm.

9. The organic electroluminescent device as claimed in any of the preceding claims, wherein the interlayer dielectric layer (348) further comprises a plurality of second openings (354), exposing the first and second gates (330, 332)and a portion of the first and second active areas, and the second openings are filled with conductive contacts (356).

10. The organic electroluminescent device as claimed in any of the preceding claims, wherein the device is a display panel (30).

11. The organic electroluminescent device as claimed in claim 10, further comprising an electronic device, wherein the electronic device comprises:
the display panel (30); and
an input unit (40) coupled to the display panel and operative to provide input to the display panel such that the display panel displays images.

12. A method for forming an organic electroluminescent device, comprising:
providing a substrate (302) comprising a control area (304) and a sensitive area (306);
forming a first conductivity type TFT in the control area (304) and a first conductivity type region of a photo diode in the sensitive area (306); and
forming a second conductivity type TFT in the control area and a second conductivity type region of the photo diode in the sensitive area;
wherein formation of the first conductivity type TFT and the first conductivity type region of the photo diode comprises:
forming a first, second, third, and fourth active layers overlying the substrate, wherein the first and second active layers (310, 312) are in the control area (304), wherein the third and fourth active layers (3101, 3121) are in the sensitive area (306);
performing an implantation, forming a channel region (320) in the first active layer (310);
performing an implantation, forming a first conductive region (3121a)in the fourth active layer (3121);
forming a gate dielectric layer (328) overlying the first, second, third, and fourth active layers; and
forming a first (330) and second (332) gates overlying the first (310) and second (312) active layers, respectively, wherein the first gate (330), gate dielectric layer (328), and first active layer (310) constitute the first conductivity type TFT, wherein the fourth active layer (3121) and gate dielectric layer (328) constitute the first conductivity type region of the photo diode;
said method further comprising:
forming an interlayer dielectric layer (348) overlying the first, second gate and gate dielectric layer;
forming a plurality of first openings (3481) through the gate dielectric layer overlying the sensitive area until a portion of the third active layer (3101) and of the fourth active layer (3121) are exposed;
filling the first openings with a first conductive layer (349a) such that the first conductive layer (349a) is connected both to the third and fourth active layer (3101, 3121); and
forming a layer of dielectric (349b) overlying the first conductive layer (349a).

13. The method as claimed in claim 12, wherein the first conductivity type comprises N type, the second conductivity type comprises P type.

14. The method as claimed in any of claims 12 or 13, wherein formation of the first conductivity type TFT and the first conductivity type region of the photo diode further comprises:
performing an implantation with the first and second gates (330, 332) serving as masks, thus an LDD region is formed in the first active layer, and the second active layer is lightly doped.

15. The method as claimed in any of claims 12 to 14, wherein formation of the second conductivity type TFT and the second conductivity type region of the photo diode comprises:
performing an implantation, thus a source/drain region (344, 346) in the second active layer (312) and a second conductive region in the third active layer are formed.

16. The method as claimed in any of claims 12 to 15, further comprising:
forming a plurality of second openings (354) through the gate dielectric layer overlying the control area until a portion of the first gate (330) and of the second gate (332) are exposed;
filling the second openings with second conductive contacts (356);
forming a passivation layer (362) and a planarization layer (364);
forming a pixel electrode and a pixel defined layer; and
forming an OLED element (372) overlying a portion of the control area (304) and the sensitive area (306).

## Patentansprüche

1. Organische Elektrolumineszenzvorrichtung, umfassend ein Pixelelement (20), welches Pixelelement umfasst:
ein Substrat (302), das einen Steuerbereich (304) und einen empfindlichen Bereich (306) aufweist;
eine Schalteinrichtung (206) und eine Treibereinrichtung (204), die über dem Steuerbereich angeordnet sind, wobei die Schalteinrichtung (206) eine erste aktive Schicht (310) aufweist, die Treibereinrichtung (204) eine zweite aktive Schicht (312) aufweist, wobei es sich bei der ersten und zweiten aktiven Schicht um Polysilizium-Schichten handelt;
eine Fotodiode (210), welche oberhalb des empfindlichen Bereichs angeordnet ist, wobei die Fotodiode als Fotosensor dient;
ein OLED-Element (202), das in dem empfindlichen Bereich (306) vorgesehen ist und den Fotosensor beleuchtet; und
einen Kondensator (208) der mit dem Fotosensor und der Treibereinrichtung verbunden ist;
wobei von der Fotodiode in Reaktion auf eine Beleuchtung der Fotodiode durch das OLED-Element ein Fotostrom erzeugt wird, der einer Helligkeit des OLED-Elements (202) entspricht, so dass eine Spannung des Kondensators durch den Fotostrom eingestellt wird, um den durch die Treibereinrichtung fließenden Strom zu steuern, um so die Beleuchtung des OLED-Elements zu verändern;
**dadurch gekennzeichnet, dass** die Fotodiode umfasst:
eine dritte aktive Schicht (3101), eine vierte aktive Schicht (3121) und eine fünfte aktive Schicht (349a), wobei die fünfte aktive Schicht sowohl mit der dritten aktiven Schicht als auch der vierten aktiven Schicht verbunden ist;
wobei die organische Elektrolumineszenzeinrichtung außerdem umfasst:
eine dielektrische Gate-Schicht (328), die oberhalb der ersten, der zweiten, der dritten und der vierten aktiven Schicht angeordnet ist und diese bedeckt;
ein erstes Gate (330) und ein zweites Gate (332), die auf der dielektrische Gate-Schicht und den Steuerbereich bedeckend angeordnet sind, wobei das erste Gate sich in Schalteinrichtung befindet und das zweite Gate sich in der Treibereinrichtung befindet; und
eine dielektrische Zwischenschicht (348), die auf der die elektrischen Gate-Schicht (328) vorgesehen ist und den empfindlichen Bereich bedeckt, wobei die deelektrische Zwischenschicht eine Mehrzahl von darin ausgebildeten ersten Öffnungen (3481) aufweist, so dass die dritte (3101) und vierte (3121) aktive Schicht freiliegend sind, wobei die ersten Öffnungen mit der fünften aktiven Schicht (349a) gefüllt sind.

2. Organische Elektrolumineszenzvorrichtung nach Anspruch 1, wobei die Schalteinrichtung (206) und die Treibereinrichtung (204) Top-Gate-Transistoren sind.

3. Organische Elektrolumineszenzvorrichtung nach einem der vorhergehenden Ansprüche, wobei die Fotodiode eine seitliche Fotodiode ist.

4. Organische Elektrolumineszcnzvorrichtung nach einem der vorhergehenden Ansprüche, wobei die dritte (3101) und vierte (3121) aktive Schicht Polysilizium sind.

5. Organische Elektrolumineszenzvorrichtung nach einem der vorhergehenden Ansprüche, wobei die dritte (3101) und vierte (3121) aktive Schicht von einem unterschiedlichen Leitfähigkeitstyp sind.

6. Organische Elektrolumincszcnzvorrichtung nach Anspruch 5, wobei die dritte aktive Schicht (3101) eine p-leitende Schicht ist und die vierte aktive Schicht (3121) eine n-leitende Schicht ist.

7. Organische Elektrolumineszenzvomchtung nach einem der vorhergehenden Ansprüche, wobei die fünfte aktive Schicht (349a) amorphes Silizium ist.

8. Organische Elektrolumineszenzvorrichtung nach einem der vorhergehenden Ansprüche, wobei die fünfte aktive Schicht (349a) eine Dicke zwischen 450 bis 550 nm aufweist.

9. Organische Elektrolumineszenzvorrichtung nach einem der vorhergehenden Ansprüche, wobei die deelektrische Zwischenschicht (348) außerdem eine Mehrzahl von zweiten Öffnungen (354) aufweist, welche das erste und zweite Gate (330, 332) und einen Abschnitt des ersten und zweiten aktiven Bereichs freilegen, und wobei die zweiten Öffnungen mit leitfähigen Kontakten (356) gefüllt sind.

10. Organische Elektrolumineszenzvorrichtung nach einem der vorhergehenden Ansprüche, wobei es sich bei der Vorrichtung um ein Anzeigefeld (30) handelt.

11. Organische Elektrolumineszenzvorrichtung nach Anspruch 10, weiterhin umfassend eine elektronische Einrichtung, wobei die elektronische Einrichtung umfasst:
das Anzeigefeld (30); und
eine Eingabeeinheit (40), die mit dem Anzeigefeld verbunden ist und betätigt werden kann, um Für eine Eingabe für das Anzeigefeld zu sorgen, so dass das Anzeigefeld Bilder anzeigt.

12. Verfahren zum Ausbilden einer organischen Elektrolumineszenzvorrichtung, mit den Schritten:
Bereitstellen eines Substrats (302), das einen Steuerbereich (304) und einen empfindlichen Bereich (306) aufweist;
Ausbilden eines TFT eines ersten Leitfähigkeitstyps in dem Steuerbereich (304) und eines Abschnitts einer Fotodiode eines ersten Leitfähigkeitstyps in dem empfindlichen Bereich (306); und
Ausbilden eines TFT eines zweiten Leitfähigkeitstyps in dem Steuerbereich und eines Abschnitts der Fotodiode des zweiten Leitfähigkeitstyps in dem empfindlichen Bereich;
wobei die Ausbildung des TFT des ersten Leitfähigkeitstyps und des Abschnitts der Fotodiode des ersten Leitfähigkeitstyps die Schritte umfasst:
Ausbilden einer ersten, zweiten, dritten und vierten aktiven Schicht, die das Substrat bedecken, wobei sich die erste und zweite aktive Schicht (310, 312) in dem Steuerbereich (304) befinden, wobei die dritte und vierte aktive Schicht (3101, 3121) in dem empfindlichen Bereich (306) liegen;
Ausführen eines Implantierungs- bzw. Dotierungsschrittes, um einen Kanalbereich (320) in der ersten aktiven Schicht (310) auszubilden;
Ausführen eines Implantierungs- bzw. Dotierungsschrittes, um einen ersten leitenden Bereich (3121 a) in der vierten aktiven Schicht (3121) auszubilden;
Ausbilden einer dielektrischen Gate-Schicht (328), welche die erste, zweite, dritte und vierte aktive Schicht überdeckt; und
Ausbilden eines ersten (330) und zweiten (332) Gates, die die erste (310) bzw. zweite (312) aktive Schicht bedecken, wobei das erste Gate (330), die dielektrische Gate-Schicht (328) und die erste aktive Schicht (310) den TFT des ersten Leitfähigkeitstyps ausbilden, wobei die vierte aktive Schicht (3121) und die dielektrische Gate-Schicht (328) den Abschnitt der Fotodiode des ersten Leitfähigkeitstyps ausbilden;
welches Verfahren außerdem die Schritte umfasst:
Ausbilden einer dielektrischen Zwischenschicht (348), welche das erste Gate, das zweite Gate und die dielektrische Gate-Schicht überdeckt;
Ausbilden einer Mehrzahl von ersten Öffnungen (3481) durch die dielektrische Gate-Schicht hindurch, welche den empfindlichen Bereich überdeckt, solange bis ein Abschnitt der dritten aktiven Schicht (3101) und der vierten aktiven Schicht (3121) freiliegen;
Auffüllen der ersten Öffnungen mit einer ersten leitfähigen Schicht (349a), so dass die erste leitfähige Schicht (349a) sowohl mit der dritten aktiven Schicht als auch mit der vierten aktiven Schicht (3101, 3121) verbunden ist; und
Ausbilden einer Schicht aus Dielektrika (349b), welche die erste leitende Schicht (349a) überdeckt.

13. Verfahren nach Anspruch 12, wobei der erste Leitfähigkeitstyp n-leitend ist und der zweite Leitfähigkeitstyp p-leitend ist.

14. Verfahren nach einem der Ansprüche 12 oder 13, wobei die Ausbildung des TFT des ersten Leitfähigkeitstyps und des Abschnitts der Fotodiode des ersten Leitfähigkeitstyps außerdem umfasst:
Ausführen eines Implantierungs- bzw. Dotierungsschrittes, bei dem das erste und zweite Gate (330, 332) als Masken wirken, so dass ein LDD-Bereich in der ersten aktiven Schicht ausgebildet ist und die zweite aktive Schicht leicht dotiert ist.

15. Verfahren nach einem der Ansprüche 12 bis 14, wobei die Ausbildung des TFT des zweiten Leitfähigkeitstyps und des Abschnitts der Fotodiode des zweiten Leitfahigkeitstyps umfasst:
Ausfahren eines Implantierungs- bzw. Dotierungsschnittes, so dass ein Source-/Drain-Bereich (344, 346) in der zweiten aktiven Schicht (312) und ein zweiter Leitfähigkeitsbereich in der dritten aktiven Schicht ausgebildet werden.

16. Verfahren nach einem der Ansprüche 12 bis 15, außerdem umfassend:
Ausbilden einer Mehrzahl von zweiten Öffnungen (354) durch die dielektrische Gate-Schicht hindurch, welche den Steuerbereich bedeckt, solange bis ein Abschnitt des ersten Gates (330) und des zweiten Gates (332) freiliegen;
Auffüllen der zweiten Öffnungen mit zweiten leitenden Kontakten (356);
Ausbilden einer Passivierungsschicht (362) und einer Planarisierungsschicht (364);
Ausbilden einer Pixelelektrode und einer Pixel-Festlegungsschicht; und
Ausbilden eines OLED-Elements (372), welche einen Abschnitt des Steuerbereichs (304) und des empfindlichen Bereichs (306) Überdeckt.

## Revendications

1. Un dispositif électro-luminescent organique, comportant un élément de pixel (20), lequel élément de pixel comporte:
un substrat (302), comportant une zone de commande (304) et une zone sensible (306) ;
un dispositif commutateur (206) et un dispositif de pilotage (204) recouvrant la zone de commande, dans laquelle le dispositif commutateur (206) a une première couche active (310), le dispositif de pilotage (204) ayant une seconde couche active (312), les premières et secondes couches actives étant des couches de polysilicium ;
une photodiode (210) recouvrant la zone sensible, dans laquelle la photodiode sert comme un capteur optique ;
un élément OLED (202) disposé dans la zone sensible (306) et illuminant le capteur optique ; et
un condensateur (208) couplé au capteur optique et au dispositif de pilotage ;
dans lequel un photocourant correspondant à la luminosité de l'élément OLED (202) est généré au moyen de la photodiode réagissant à l'élément d' OLED illuminant la photodiode de telle manière que le potentiel aux bornes du condensateur est ajusté par le photocourant pour commander le courant traversant le dispositif de pilotage, provoquant ainsi la variation de la luminosité de l'élément OLED ;
**caractérisé en ce que** ladite photodiode comporte :
une troisième couche active (3101), une quatrième couche active (3121), et une cinquième couche active (349a), la cinquième couche active étant connectée aux troisième et quatrième couches actives ;
ledit dispositif électro-luminescent organique comportant en outre :
une couche diélectrique de porte (328) disposé en recouvrement de la première, la seconde, la troisième et la quatrième couches actives ;
une première porte (330) et une seconde porte (332) disposée sur la couche diélectrique de porte recouvrant la zone de commande, dans laquelle la première porte est dans le dispositif commutateur, et la deuxième porte est dans le dispositif de pilotage ; et
une couche diélectrique de couche intermédiaire (348) disposée sur la couche diélectrique de porte (328) recouvrant la zone sensible, la couche diélectrique de couche intermédiaire ayant une pluralité des premières ouvertures (3481) en son sein pour l'exposition des troisième (3101) et quatrième (3121) couches actives, dans lesquelles les premières ouvertures sont remplies de la cinquième couche active (349a).

2. Le dispositif électro-luminescent organique selon la revendication 1, dans lequel le dispositif commutateur (206) et le dispositif de pilotage (204) sont des transistors de porte supérieurs.

3. Le dispositif électro-luminescent organique selon l'une des revendications précédentes, dans lequel la photodiode est une photodiode latérale.

4. Le dispositif électro-luminescent organique selon l'une des revendications précédentes, dans lequel la troisième (3101) et quatrième (3121) couches actives sont en polysylicone.

5. Le dispositif électro-luminescent organique selon l'une des revendications précédentes, dans lequel la troisième (3101) et quatrième (3121) couches actives présentent des types de conductivité différents.

6. Le dispositif électro-luminescent organique selon la revendication 5, dans lequel la troisième couche active (3101) présente une conductivité de type P et la quatrième couche active (3121) présente une conductivité de type N.

7. Le dispositif électro-luminescent organique selon l'une des revendications précédentes, dans lequel la cinquième couche active (349a) est du silicium amorphe.

8. Le dispositif électro-luminescent organique selon l'une des revendications précédentes, dans lequel la cinquième couche active (349a) a une épaisseur entre 450-550 Angström.

9. Le dispositif électro-luminescent organique selon l'une des revendications précédentes, dans lequel la couche diélectrique de couche intermédiaire (348) comporte en outre une pluralité d' ouvertures secondaires (354), exposant la première et seconde portes (320, 332) et une partie de la première et seconde zones actives, et les deuxièmes ouvertures sont remplis de contacts conducteurs (356).

10. Le dispositif électro-luminescent organique selon l'une des revendications précédentes dans lequel le dispositif est un panneau d'affichage (30).

11. Le dispositif électro-luminescent organique selon la revendication 10, comportant en outre un dispositif électronique, dans lequel le dispositif électronique comporte :
le panneau d'affichage (30) ; et
une unité d'entrée (40) couplée au panneau d' affichage et servant à fournir des données au panneau d'affichage afin qu'il affiche des images.

12. Une méthode pour former un dispositif électro-luminescent organique, comportant:
la fourniture d'un substrat (302) comportant une zone de commande (304) et une zone sensible (306) ;
la fourniture d'un premier type de conductivité TFT dans la zone de commande (304) et d'une région présentant un premier type de conductivité de photodiode dans la zone sensible (306) ; et
la fourniture d'un second type de conductivité TFT dans la zone de commande et d'une région présentant un second type de conductivité de photodiode dans la zone sensible;
dans laquelle la formation du premier type de conductivité TFT et de la région présentant le premier type de conductivité de photodiode comporte :
la formation d' une première, d'une seconde, d'une troisième, et d'une quatrième couche active recouvrant le substrat, dans laquelle les première et seconde couches actives (310, 312) sont dans la zone de commande (304), les troisième et quatrième couches actives (3101, 3121) étant dans la zone sensible (306) ;
une implantation, en vue de la formantion d' une région de canal (320) dans la première couche active (310) ;
une implantation, en vue de la formantion d'une première région conductrice (3121 a) dans la quatrième couche active (3121) ;
la formation d'une couche diélectrique de porte (328) recouvrant la première, la seconde, la troisième, et la quatrième couche active ; et
la formation d'une première (330) et une deuxième porte (332) recouvrant la première (310) et la deuxième (312) couches actives, respectivement, dans lesquelles la première porte (330), la couche diélectrique de porte (328), et la première couche active (310) constituent le premier type de conductivité TFT, dans laquelle la quatrième couche active (3121) et la couche diélectrique de porte (328) constituent la région présentant le premier type de conductivité de photodiode ;
ladite méthode comportant en outre :
la formation d'une couche diélectrique intermédiaire (348) recouvrant la première, la deuxième porte et la couche diélectrique de porte :
la formation d'une pluralité d' ouvertures primaires (3481) au travers de la couche diélectrique de porte recouvrant la zone sensible jusqu'à ce qu' une partie de la troisième couche active (3101) et de la quatrième couche active (3121) soient exposées ;
le remplissage des premières ouvertures avec une première couche conductrice (349a) tels que la première couche conductrice (349a) est connectée à la troisième et quatrième couche active (3101, 3121) ; et
la formation d'une couche diélectrique (349b) recouvrant la première couche conductrice (349a).

13. La méthode selon la revendication 12, dans laquelle le premier type de conductivité est de type N, le second type de conductivité est de type P.

14. La méthode selon l'une quelconque des revendications 12 ou 13, dans laquelle la formation du premier type de conductivité TFT et la région présentant le premier type de conductivité de la photodiode comporte en outre :
une implantation avec les premières et secondes portes (330, 332) servant de masques, de manière à former une région LDD au sein de la première couche active, et à légèrement doper la seconde couche active..

15. La méthode selon l'une quelconque des revendications 12 à 14, dans laquelle la formation du deuxième type de conductivité TFT et de la région présentant le second type de conductivité de la photodiode comporte :
une implantation de manière à former une région de source/drain (344, 346) dans la seconde couche active (312) ainsi qu'une seconde région conductrice au sein de la troisième couche active.

16. La méthode selon l'une quelconque des revendications 12 à 15, comportant en outre :
la formation d'une pluralité d' ouvertures secondaires (354) au travers de la couche diélectrique de porte recouvrant la zone de commande jusqu'à l'exposition d'une partie de la première porte (330) et de la deuxième porte (332) ;
le remplissage des ouvertures secondaires au moyen de second contacts conducteurs (356) ;
la formation d'une couche de passivation (362) et d'une couche de planarisation (364) ;
la formation d'une électrode de pixel et d'une couche de définition de pixel ; et
la formation d'un élément d'OLED (372) recouvrant une partie de la zone de commande (304) et la zone sensible (306).
